# EUROPÄISCHE PATENTSCHRIFT

(11) **EP 2 718 957 B1**
(45) Veröffentlichungstag und Bekanntmachung des Hinweises auf die Patenterteilung: **29.07.2015**
(21) Anmeldenummer: 12728050.1
(22) Anmeldetag: 06.06.2012
(51) Int. Cl.: H01J 37/32

(54) **VERFAHREN ZUR ERZEUGUNG EINES ARCERKENNUNGSSIGNALS UND ARCERKENNUNGSANORDNUNG**
METHOD AND DEVICE FOR GENERATING AN ARC DETECTION SIGNAL AND ARC DETECTION ARRANGEMENT
PROCÉDÉ DE GÉNÉRATION D'UN SIGNAL DE DÉTECTION D'ARC ET ENSEMBLE DE DÉTECTION D'ARC

(30) Priorität: 07.06.2011 DE 102011077152
(43) Veröffentlichungstag der Anmeldung: 16.04.2014
(73) Patentinhaber: TRUMPF Hüttinger GmbH + Co. KG, 79111 Freiburg im Breisgau (DE)
(72) Erfinder: BANNWARTH, Markus, 79111 Freiburg i.Br. (DE); FRITSCH, Christian, 79183 Waldkirch (DE); HELLER, Ulrich, 79206 Gündlingen (DE); KRAUSSE, Daniel, Mountain View, CA 94043, APT No. 21 (US); MERTE, Rolf, 79117 Freiburg (DE); NITSCHKE, Moritz, 79114 Freiburg (DE); WIEDEMUTH, Peter, 79336 Herbolzheim (DE); BOCK, Christian, 79108 Freiburg i.Br. (DE); GLÜCK, Michael, 79111 Freiburg (DE); KIRCHMEIER, Thomas, 79331 Teningen (DE); MANN, Ekkehard, 79194 Gundelfingen (DE); NEDUNURI, Krishna Kishore, 59494 Soest (DE); STEUBER, Martin, 79426 Buggingen (DE); WINTERHALTER, Markus, 79189 Bad Krozingen (DE)
(86) Internationale Anmeldenummer: PCT/EP2012/060707
(87) Internationale Veröffentlichungsnummer: WO 2012/168303

(56) Entgegenhaltungen:
- WO-A1-2008/150136
- DE-A1-102007 056 468
- US-A1- 2006 241 879
- US-A1- 2009 207 537

## Beschreibung

Die Erfindung betrifft ein Verfahren zur Erzeugung eines Arcerkennungssignals auf Basis mehrerer Beobachtungssignale und eine Arcerkennungsanordnung eines Plasmasystems zur Erzeugung eines Arcerkennungssignals.

Bei einem Plasma handelt es sich um einen besonderen Aggregatzustand, der aus einem Gas erzeugt wird. Jedes Gas besteht grundsätzlich aus Atomen und/oder Molekülen. Bei einem Plasma ist dieses Gas zu einem Großteil ionisiert. Dies bedeutet, dass durch Zufuhr von Energie die Atome bzw. Moleküle in positive und negative Ladungsträger, also in Ionen und Elektronen, aufgespaltet werden. Ein Plasma eignet sich zur Bearbeitung von Werkstücken, da die elektrisch geladenen Teilchen chemisch hochgradig reaktiv und zudem durch elektrische Felder beeinflussbar sind. Die geladenen Teilchen können mittels eines elektrischen Feldes auf ein Objekt beschleunigt werden, wo sie beim Aufprall einzelne Atome daraus herauslösen können. Die herausgelösten Atome können über Gasfluss abtransportiert werden (Ätzen) oder auf anderen Objekten als Beschichtung abgelagert werden (Herstellung von Dünnfilmen). Anwendung findet eine solche Bearbeitung mittels eines Plasmas vor allem dann, wenn extrem dünne Schichten, insbesondere im Bereich weniger Atomlagen, bearbeitet werden sollen. Typische Anwendungen sind Halbleitertechnik (Beschichten, Ätzen, etc.), Flachbildschirme (ähnlich Halbleitertechnik), Solarzellen (ähnlich Halbleitertechnik), Architekturglasbeschichtung (Wärmeschutz, Blendschutz, etc.), Speichermedien (CD, DVD, Festplatten), dekorative Schichten (farbige Gläser, etc.) und Werkzeughärtung. Diese Anwendungen haben hohe Anforderungen an Genauigkeit und Prozessstabilität. Weiterhin kann ein Plasma auch zur Anregung von Lasern, insbesondere Gaslasern, dienen.

Um aus einem Gas ein Plasma zu generieren, muss ihm Energie zugeführt werden. Das kann auf unterschiedliche Weise, beispielsweise über Licht, Wärme, elektrische Energie, erfolgen. Ein Plasma zur Bearbeitung von Werkstücken wird typischerweise in einer Plasmakammer gezündet und aufrecht erhalten. Dazu wird in der Regel ein Edelgas, z. B. Argon, mit niedrigem Druck in die Plasmakammer geleitet. Über Elektroden und/oder Antennen wird das Gas einem elektrischen Feld ausgesetzt. Ein Plasma entsteht bzw. wird gezündet, wenn mehrere Bedingungen erfüllt sind. Zunächst muss eine geringe Anzahl von freien Ladungsträgern vorhanden sein, wobei zumeist die stets in sehr geringem Maß vorhandenen freien Elektronen genutzt werden. Die freien Ladungsträger werden durch das elektrische Feld so stark beschleunigt, dass sie beim Aufprall auf Atome oder Moleküle des Edelgases weitere Elektronen herauslösen, wodurch positiv geladene Ionen und weitere negativ geladene Elektronen entstehen. Die weiteren freien Ladungsträger werden wiederum beschleunigt und erzeugen beim Aufprall weitere Ionen und Elektronen. Es setzt ein Lawineneffekt ein. Der ständigen Erzeugung von Ionen und Elektronen wirken die Entladungen bei der Kollision dieser Teilchen mit der Wand der Plasmakammer oder anderen Gegenständen sowie die natürliche Rekombination entgegen, d. h., Elektronen werden von Ionen angezogen und rekombinieren zu elektrisch neutralen Atomen bzw. Molekülen. Deshalb muss einem gezündeten Plasma beständig Energie zugeführt werden, um dieses aufrecht zu erhalten.

Die Energiezufuhr kann über eine Gleichstrom (DC)- oder eine Wechselstrom (AC)-Leistungsversorgung erfolgen. Die bei Plasmaanregung mit einer AC-Leistungsversorgung vorkommenden Frequenzen können bis in den Gigahertzbereich hinein liegen.

Im Plasma kann es zu kurzzeitigen und auch länger anhaltenden Überschlägen, so genannten Arcs, kommen, die unerwünscht sind. Wenn ein solcher Arc erkannt wird, muss dafür gesorgt werden, dass dieser möglichst rasch erlischt, bzw. sich nicht voll entfaltet.

Bei einem Plasmaprozess lassen sich verschiedene Signale zur Arc-Erkennung heranziehen, die entsprechende Indizien für einen Arc zeigen, beispielsweise die reflektierte Leistung, das Verhältnis von reflektierter Leistung zur Vorwärtsleistung, Strom, Spannung, Phasenwinkel, Helligkeit des Plasmas, gegebenenfalls auf einer oder mehreren bestimmten optischen Wellenlängen, akustische Signale, entstehender DC-Bias, Signale von einer Antenne in der Plasmakammer etc. Mathematische Operationen auf diesen Signalen (z.B. Betrachtung der Steigung durch Ableiten eines Signals, Filterung) können die Empfindlichkeit erhöhen.

Die Arc-Erkennung mit festen Schwellwerten ist oft entweder nicht sicher genug oder zu stringent. Außerdem ist sie nicht flexibel genug, um auf wechselnde Betriebsparameter zu reagieren.

US 2009/207537 A1 offenbart ein Verfahren zur Erzeugung eines Arc-Erkennungssignals auf Basis mehrerer Beobachtungssignale mittells einem Auswertungsmodul, das durch eine Korrelationsfunktion Durchschläge in der Plasmakammer auf Grund von einem ersten und zweiten Signal erkennen kann.

Aufgabe der vorliegenden Erfindung ist es, ein Verfahren und eine Vorrichtung bereit zu stellen, mit denen Arcs zuverlässiger erkannt werden können.

Gelöst wird diese Aufgabe durch ein Verfahren zur Erzeugung eines Arcerkennungssignals auf Basis mehrerer Beobachtungssignale gemäß Anspruch 1.

Durch die geeignete Zusammenführung (Kombination) von Beobachtungssignalen in einem Kombinator zu einem gemeinsamen Arc-Erkennungssignal können die Geschwindigkeit und Sicherheit der Arc-Erkennung erhöht werden. Mit dem erfindungsgemäßen Verfahren ist es insbesondere möglich, eine solche Kombination von Signalen zu einem Arc-Erkennungssignal automatisch (selbstlernend) so erfolgen zu lassen, dass die Koeffizienten bei der Addition zu einem besseren Signal-Rausch-Verhältnis führen. Vorzugsweise ist jedem Beobachtungssignal ein eigener Koeffizient zugeordnet, so dass das Beobachtungssignal bzw. das daraus resultierende Arc-Erkennungsteilsignal mit einem eigenen Koeffizienten gewichtet werden kann und mit dieser Wichtung in das Arc-Erkennungssignal eingehen kann.

Als Korrelationssignal kann ein Signal verwendet werden, das mit einem vorher ermittelten Arc-Erkennungssignal in Beziehung steht. Insbesondere kann das Korrelationssignal, beispielsweise ein elektrisches Signal, bei Arcerkennung eine deutliche Veränderung des Signalverlaufs gegenüber einem Signalverlaufs ohne Arc-Erkennung aufweisen.

Ein Korrelationssignal kann auch ein Arc-Erkennungssignal sein, das die Arc-Erkennung auf unabhängigem Weg ermittelt, z.B. mittels eines von der noch zu beschreibenden Arc-Erkennungsanordnung unabhängigen Beobachtungssignals. Das könnte z.B. ein Signal sein, das von einer optischen oder akustischen Überwachung in der Plasmakammer generiert wird.

Weiterhin kann ein Korrelationssignal ein extern erzeugtes Signal sein, das ein Arc-Verhalten im Plasmasystem verursacht oder simuliert. Beispielsweise kann ein externer Signalerzeuger einen energiereichen Impuls in das Plasma einspeisen. Dieser Impuls könnte durch einen Signalgenerator erzeugt werden. Der Ausgang des Signalgenerators, der Impuls selbst oder gefilterte oder modifizierte Signale dieser Signale könnten als Korrelationssignale verwendet werden.

Das Korrelationssignal kann mit dem Beobachtungssignal oder einem modifzierten Beobachtungssignal multipliziert werden.

Unter einem modifzierten Beobachtungssignal wird beispielsweise ein Signal verstanden, das erhalten wird, wenn das Beobachtungssignal mit einer Schwelle verglichen wird, wobei nur ein Signal als modifiziertes Beobachtungssignal ausgegeben wird, wenn die Schwelle überschritten wird. Alternativ kann das Beobachtungssignal mit einer Nichtlinearität versehen oder gefiltert werden, um ein modifziertes Beobachtungssignal zu erhalten.

Gemäß einer Verfahrensvariante kann vorgesehen, dass das Korrelationsergebnis mit einem Faktor multipliziert wird. Gemäß einer Verfahrensvariante kann vorgesehen sein, dass das mit einem Faktor multiplizierte Korrelationsergebnis vorzeichenrichtig zu dem Koeffizienten zur Bildung eines aktualisierten Koeffizienten addiert wird. Der Faktor weist dabei vorzugsweise Werte kleiner eins auf. Grundsätzlich ist es denkbar, den Faktor konstant zu halten, wobei jedem Koeffizienten ein eigener Faktor zugeordnet sein kann.

Weiterhin kann vorgesehen sein, dass je länger ein Plasmaprozess läuft (dabei kann es sich beispielsweise um einen Lernprozess handeln) der Faktor immer kleiner wird. Insbesondere kann der Faktor nach einer vorgegebenen Vorschrift mit der Zeit fallen. Je kleiner der Faktor wird, desto stabiler werden die Koeffizienten gehalten. Der Faktor kann also variabel sein. Außerdem ist es denkbar, dass der Faktor nach einer bestimmten Zeit auf Null gesetzt wird.

Bleibt der Faktor ungleich null, so kann auch bei laufendem Betrieb eines Plasmaprozesses die Wichtung der Beobachtungssignale permanent angepasst werden.

Das erfindungsgemäße Verfahren zeichnet sich dadurch aus, dass die Koeffizienten für die Beobachtungssignale mit hohen Unregelmäßigkeiten (starken Indizien, dass ein Arc vorliegt) schneller wachsen. Derartige Signale gehen dann stärker, d.h. mit einer höheren Wichtung, in das Arc-Erkennungssignal ein. Dadurch wird die Arc-Detektion immer zuverlässiger.

Vorteilhafterweise kann für jedes Beobachtungssignal ein Startkoeffizient vorgegeben werden. Beispielsweise kann für ein Beobachtungssignal, bei dem mit relativ großer Wahrscheinlichkeit eine Unregelmäßigkeit beim Auftreten eines Arcs eintreten wird, der Koeffizient gleich eins gesetzt werden. Dies bedeutet, dass dieses Beobachtungssignal zunächst allein das Arc-Erkennungssignal bildet. Tritt ein auf einen Arc hindeutendes Ereignis ein, so wird in allen anderen Signalen nach einer Unregelmäßigkeit als Indikator gesucht, dass in diesem Signal ebenfalls ein Arc beobachtet wurde, d.h. der Arc zu einer Unregelmäßigkeit im Signal geführt hat. Die diesen Signalen zugeordneten Koeffizienten werden dann aktualisiet, und zwar um die Unregelmäßigkeit multipliziert mit dem Faktor. War die Unregelmäßigkeit negativ, so wird der Koeffizient verringert. War die Unregelmäßigkeit positiv, wird der Koeffizient erhöht. Der Koeffizient stellt also einen Integrator dar, dessen Inhalt bei jedem erkannten Arc ein wenig wachsen oder fallen kann.

Gemäß einer Verfahrensvariante kann vorgesehen sein, dass das Korrelationssignal ein Arc-Erkennungssignal, insbesondere ein vorher oder unabhängig vom erfindungsgemäßen Verfahren generiertes Arc-Erkennungssignal, ist. Demnach kann das Arc-Erkennungssignal direkt in die Erneuerung bzw. Aktualisierung der Koeffizienten eingehen. Bei einer stufenlosen Betrachtung kann das Arc-Erkennungssignal dauernd mit dem die Unregelmäßigkeiten aufweisenden Beobachtungssignal multipliziert werden, um mit diesem Ergebnis den entsprechenden Koeffizienten erneuern zu können. Dabei sollte aus Stabilitätsgründen auf einen kleinen Faktor geachtet werden. Es ist jedoch auch denkbar, dass das Arc-Erkennungssignal einem Entscheidungsglied zugeführt wird und das Ausgangssignal des Entscheidungsglieds als Korrelationssignal verwendet wird. Beispielsweise kann das Entscheidungsglied ein Arc-Detektor sein, der aufgrund des Arc-Erkennungssignals entscheidet, ob ein Arc vorliegt oder nicht. Das Ausgangssignal des Arc-Detektors kann als Korrelationssignal verwendet werden.

Anstatt eines einfachen Entscheidungsprozesses Arc/kein Arc kann eine weichere Entscheidung mit mehreren Stufen oder auch eine stufenlose Betrachtung/Bewertung des Arc-Erkennungssignals erfolgen. Die Multiplikation bzw. Erneuerung der Koeffizienten können vom Über-/Unterschreiten einer oder mehrerer Schwellen durch das Arc-Erkennungssignals abhängig gemacht werden. Insbesondere kann ein im Arc-Erkennungssignal detektiertes "kleines" Arc-Ereignis zwar die bei der Plasmaanlage vorgesehene Arc-Maßnahme auslösen, jedoch können die Koeffizienten nur bei einem genügend großen Arc-Ereignis erneuert werden. Hierzu kann im Entscheidungsglied das Arc-Erkennungssignal mit einer oder mehreren Schwellen verglichen werden. Alternativ kann das Arc-Erkennungssignal mit einem Offset versehen werden und/oder kann auf das Arc-Erkennungssignal eine Nichtlinearität angewendet werden. Das resultierende Signal stellt dann das Korrelationssignal dar. Beispielsweise kann das Arc-Erkennungssignal quadriert werden und das quadrierte Signal als Korrelationssignal zur Erneuerung der Koeffizienten verwendet werden.

Zumindest ein Beobachtungssignal kann mit zumindest einer Schwelle verglichen werden oder auf das Beobachtungssignal kann eine Nichtlinearität angewendet werden, ehe es mit dem Korrelationssignal korreliert wird. Auf diese Weise können Bereiche des Beobachtungssignals unterschiedlich bewertet werden und es kann eine geeignete Bewertung erfolgen.

Um die Stabilität des Systems zu garantieren, kann zumindest ein Koeffizient begrenzt werden. Vorzugsweise werden alle Koeffizienten begrenzt, d.h. es wird für alle Koeffizienten ein Wert oder für jeden Koeffizient ein eigener Wert vorgegeben, den dieser nicht überschreiten darf.

Die Koeffizienten können auch, beispielsweise mit der Summe ihrer Absolutwerte, normiert werden. Durch individuelles Berücksichtigen der Koeffizienten oder durch individuelle Korrekturen der normierten Koeffizienten (Multiplikation mit einem Faktor, Offset) können bestimmte Beobachtungssignale gewollt über- oder unterbewertet werden.

Weiterhin kann vorgesehen sein, dass zumindest ein Koeffizient mit einem Schwund beaufschlagt wird. Dies bedeutet, dass die Koeffizienten zu definierten Zeitpunkten oder Ereignissen reduziert werden. Beispielsweise können Koeffizienten bei fehlenden oder zu geringen Unregelmäßigkeiten, die auf einen Arc hinweisen, des zugeordneten Beobachtungssignals gegen Null gezogen werden. Der Schwund kann ein absoluter oder relativer Schwund sein. Er kann beispielsweise bei jedem erkannten Arc wirken. Der Schwund sollte jedoch so klein gewählt werden, dass eine genügend große Unregelmäßigkeit im Falle eines Arcs den Koeffizienten schneller oder stärker beeinflusst als der Schwund. Der Schwund kann für verschiedene Beobachtungssignale unterschiedlich sein.

Zumindest ein Beobachtungssignal kann erzeugt werden, indem ein Messsignal verstärkt, gefiltert, nach der Zeit abgeleitet, mit seinem Rauschen normiert und/oder mathematisch bearbeitet wird. Um ein optimales Signal-Rausch-Verhältnis zu erlangen, können die Beobachtungssignale vor dem Eintritt in den Kombinator auf ihr Rauschen normiert werden.

Weiterhin kann vorgesehen sein, dass zumindest ein Beobachtungssignal mit mehreren Koeffizienten gewichtet wird. Statt eines einzigen Koeffizienten für jedes Beobachtungssignal kann eine Reihe von m Koeffizienten verwendet werden (m kann für verschiedene Beobachtungssignale je nach Erfordernis unterschiedlich groß gewählt werden). Ebenso kann jedes (bzw. mindestens ein) Beobachtungssignal eine Verzögerungsleitung mit m-1 Zellen (Verzögerungsgliedern) aufweisen. Dies bedeutet, dass das zumindest ein Beobachtungssignal nach unterschiedlichen zeitlichen Verzögerungen mit einem Koeffizienten gewichtet werden kann. Insbesondere kann die Summe aus den m Koeffizienten multipliziert mit dem jeweils korrespondierenden verzögerten Beobachtungssignal gebildet werden. Dies kann für alle oder zumindest ein Beobachtungssignal erfolgen.

Für die Erneuerung eines der m Koeffizienten im Falle eines erkannten Arcs ist die jeweils in dem korrespondierenden Verzögerungsglied vorhandene Signalamplitude (Unregelmäßigkeit) maßgebend. Für jedes der Beobachtungssignale können die Koeffizienten am schnellsten wachsen, in deren zugeordneten Verzögerungsglied die größte Unregelmäßigkeit des Beobachtungssignals auftritt. Eine Arc-Erkennung findet allerdings erst statt, wenn bei einem Arc die Unregelmäßigkeiten auf die höheren Koeffizienten treffen, also spätestens nach m Takten. Um die zeitliche Stabilität zu gewährleisten, können beispielsweise die Flanken der Verzögerungskette von Kombinator kleiner bewertet werden als das Zentrum. Auf diese Weise wird der Hauptanteil der Wichtungen in den Zentren der Verzögerungsleitungen, d.h. bei den zentralen Verzögerungsgliedern, zu finden sein, was die zeitliche Relation festlegt. Sind die bei einem Arc erwarteten Unregelmäßigkeiten bei zwei Beobachtungssignalen gegeneinander verzögert, so werden auch die m Koeffizienten für diese beiden Beobachtungssignale diese Verzögerung widerspiegeln und so zu einem zeitlich enger definierten Ereignis auf dem Arc-Erkennungssignal führen.

Ebenso wird eine verbreiterte oder mit einer bestimmten Form versehene Unregelmäßigkeit auf einem Beobachtungssignal zu m Koeffizienten führen, die dieses Eingangssignal optimal auf ein zeitlich engeres Ereignis auf dem Arc-Erkennungssignal abbilden.

In den Rahmen der Erfindung fällt außerdem eine Arc-Erkennungsanordnung eines Plasmasystems gemäß Anspruch 13.

Mit einer solchen Arc-Erkennungsanordnung ist es möglich, eine Kombination von Signalen zu einem Erkennungssignal automatisch (selbstlernend) so erfolgen zu lassen, dass die Wichtungen (Koeffizienten) bei der Addition zu einem besseren Signal-Rausch-Verhältnis führen. Dadurch wird die Geschwindigkeit der Arc-Erkennung erhöht.

Der Koeffizientenerzeuger kann einen Integrator umfassen. Der Ausgang des Koeffizientenerzeugers, also der Koeffizient, kann somit bei jedem erkannten Arc ein wenig wachsen oder fallen.

Weiterhin kann ein Normierungsglied vorgesehen sein, dem die Koeffizienten zugeführt sind und dessen Ausgang mit jeweils einem Multiplikator in den Koeffizientenerzeugern verbunden ist. Durch eine Normierung kann das Signal-Rausch-Verhältnis verbessert werden.

Dem Kombinator kann ein Entscheidungsglied nachgeordnet sein, dessen Ausgang den Korrelatoren zugeführt ist. Bei dem Entscheidungsglied kann es sich beispielsweise um den eigentlichen Arc-Detektor handeln. Eine Änderung der Koeffizienten erfolgt demnach nur, wenn ein Arc erkannt wurde. Es ist jedoch auch denkbar, andere Entscheidungsglieder vorzusehen, so dass nur bei Eintritt bestimmter Ereignisse ein Signal den Korrelatoren zugeführt wird.

Zumindest ein Arc-Erkennungsteilsignalgenerator kann mehrere Verzögerungsglieder, Korrelatoren und Koeffizientenerzeuger aufweisen. Dadurch können zeitliche Unterschiede ausgeglichen werden.

Weitere Merkmale und Vorteile der Erfindung ergeben sich aus der nachfolgenden Beschreibung von Ausführungsbeispielen der Erfindung, anhand der Figuren der Zeichnung, die erfindungswesentliche Einzelheiten zeigt, sowie aus den Ansprüchen. Die dort gezeigten Merkmale sind nicht notwendig maßstäblich zu verstehen und derart dargestellt, dass die erfindungsgemäßen Besonderheiten deutlich sichtbar gemacht werden können. Die einzelnen Merkmale können je einzeln für sich oder zu mehreren in beliebiger Kombination bei Varianten der Erfindung verwirklicht sein.

In der schematischen Zeichnung sind Ausführungsbeispieie der Erfindung dargestellt und in der nachfolgenden Beschreibung näher erläutert. Es zeigen:
- Fig. 1: eine schematische Darstellung einer ersten Ausführungsform einer Arc-Erkennungsanordnung;
- Fig. 2: eine zweite Ausführungsform einer Arc-Erkennungsanordnung;
- Fig. 3: eine schematische Darstellung zur Erläuterung einer Normierung der Koeffizienten;
- Fig. 4: eine schematische Darstellung eines Teils einer Arc-Erkennungsanordnung, mit der zeitliche Verzögerungen ausgeglichen werden können;
- Fig. 5a bis 5d: jeweils ein Beobachtungssignal;
- Fig. 5e: ein Arc-Erkennungssignal;
- Fig. 5f: das Signal-Rausch-Verhältnis des Arc-Erkennungssignals der Figur 5e,
- Fig. 6a bis 6d: den Verlauf der Koeffizienten, der sich für die in Figuren 5a - 5d gezeigten Beobachtungssignale ergibt.

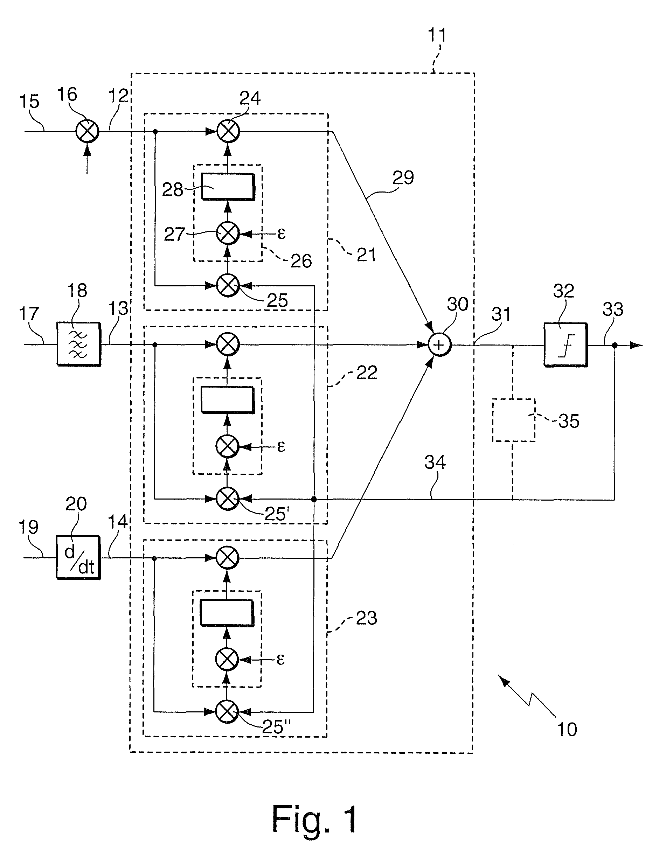

Die Figur 1 zeigt eine erste Ausführungsform einer Arc-Erkennungsanordnung 10. Die Arc-Erkennungsanordnung 10 weist einen Kombinator 11 auf, dem auf den Leitungen 12, 13, 14 im gezeigten Ausführungsbeispiel drei Beobachtungssignale zugeführt sind. Bei den Beobachtungsignalen, die auf den Leitungen 12, 13, 14 zugeführt werden, kann es sich unmittelbar um Messsignale handeln. Im gezeigten Ausführungsbeispiel wird jedoch auf der Leitung 15 ein Messsignal einem Vorverstärker 16 zugeführt. Daraus wird das auf der Leitung 12 zugeführte Beobachtungssignal erzeugt.

Auf der Leitung 17 wird ein Messsignal einer Vorfilterung 18 zugeführt. Das Ausgangssignal der Vorfilterung 18 ist das Beobachtungssignal, das dem Kombinator 11 auf der Leitung 13 zugeführt wird.

Auf der Leitung 19 wird ein Messsignal einem Ableitglied 20, das eine zeitliche Ableitung des Messsignals durchführt, zugeführt. Das Ergebnis der zeitlichen Ableitung wird als Beobachtungssignal auf der Leitung 14 dem Kombinator 11 zugeführt.

Der Kombinator 11 weist im gezeigten Ausführungsbeispiel drei Arc-Erkennungsteilsignalgeneratoren 21, 22, 23 auf. Dies bedeutet, dass für jedes Beobachtungssignal ein Arc-Erkennungsteilsignalgenerator 21 - 23 vorgesehen ist. Im gezeigten Ausführungsbeispiel sind alle Arc-Erkennungsteilsignalgeneratoren 21 - 23 identisch aufgebaut. Daher wird im Folgenden nur der Arc-Erkennungsteilsignalgenerator 21 weiter erläutert.

Das Beobachtungssignal wird über die Leitung 12 einem Multiplikator 24 zur Multiplikation des Beobachtungssignals mit einem Koeffizienten zugeführt. Weiterhin wird das Beobachtungssignal einem Korrelator 25 zur Korrelation, insbesondere Multiplikation, des Beobachtungssignals mit einem Korrelationssignal zugeführt. Das Ergebnis des Korrelators wird einem Koeffizientenerzeuger 26 zugeführt. Im Koeffizientenerzeuger 26 ist ein weiterer Multiplikator 27 angeordnet, in dem das Korrelationsergebnis mit einem Faktor ε multipliziert wird. Das Ergebnis dieser Multiplikation wird einem Integrator 28 zugeführt, dessen Ausgang den Koeffizienten darstellt, der dem Multiplikator 24 zugeführt wird. Das Ergebnis der Multiplikation im Multiplikator 24 wird als Arc-Erkennungsteilsignal auf der Leitung 29 einem Addierer 30 zugeführt. Dem Addierer 30 werden die Arc-Erkennungsteilsignale, die in den Arc-Erkennungsteilsignalgeneratoren 21 - 23 erzeugt wurden, addiert. Auf der Leitung 31 wird daher ein Arc-Erkennungssignal ausgegeben. Das Arc-Erkennungssignal wird einem Entscheidungsglied 32 zugeführt, welches das Arc-Erkennungssignal analysiert und entscheidet, z.B. durch Vergleich des Arc-Erkennungssignals mit einer Schwelle, ob ein Arc vorliegt oder nicht.

Im gezeigten Ausführungsbeispiel ist vorgesehen, dass das Arc-Signal auf der Leitung 33 über die Leitung 34 den Korrelatoren 25 der Arc-Erkennungsteilsignalgeneratoren 21 - 23 zugeführt wird. Das Arc-Signal ist im vorliegenden Ausführungsbeispiel daher das Korrelationssignal. Alternativ wäre es denkbar, ein zusätzliches Entscheidungsglied 35, welches hier nur durch gepunktete Linien angedeutet ist, vorzusehen, in dem eine andere Schwelle als die Arc-Erkennungsschwelle eingesetzt wird. Der Ausgang dieses Entscheidungsglieds 35 könnte alternativ als Korrelationssignal auf der Leitung 34 den Korrelatoren 25 zugeführt werden.

Während einer Lernphase können die Koeffizienten, die den Multiplikatoren 24 zugeführt werden, jeweils zunächst vorgegeben werden. Wenn beispielsweise auf der Leitung 15 ein Messsignal zugeführt wird, in dem mit Sicherheit ein Arc eine Unregelmäßigkeit verursacht, also ein Arc anhand des Messsignals erkannt werden kann, kann der Koeffizient, der dem Multiplikator 24 zugeführt wird, auf 1 gesetzt werden. Für die anderen Beobachtungssignale, die auf den Leitungen 13, 14 zugeführt werden, kann entsprechend der Koeffizient auf Null gesetzt werden. In diesem Fall bildet das Arc-Erkennungsteilsignal, welches auf der Leitung 29 dem Addierer 30 zugeführt wird, alleine das Arc-Erkennungssignal. Tritt ein auf einen Arc hinweisendes Ereignis (Unregelmäßigkeit) im Messsignal bzw. Beobachtungssignal, das auf der Leitung 12 zugeführt wird, auf, so wird auf der Leitung 33 ein Arc-Signal ausgegeben. In diesem Fall erfolgt eine Erneuerung der Koeffizienten, da ein Korrelationssignal auf der Leitung 34 den Korrelatoren 25 zugeführt wird. Wenn auch die Beobachtungssignale auf den Leitungen 13, 14 eine Unregelmäßigkeit, die auf einen Arc hindeutet, enthalten, so wird diese Unregelmäßigkeit in den Korrelatoren 25', 25" mit dem Korrelationssignal multipliziert. Die Koeffizienten für diese Signale werden somit erneuert und zwar um die Unregelmäßigkeit multipliziert mit einem kleinen Faktor ε. Wenn die Unregelmäßigkeit negativ war, wird der Koeffizient um einen negativen Wert korrigiert, war die Unregelmäßigkeit positiv, erfolgt die Korrektur in positiver Richtung. Der Koeffizient stellt also das Ergebnis einer Integration dar, dessen Wert bei jedem erkannten Arc ein wenig wachsen oder fallen kann. Für die weitere Detektion werden alle Beobachtungssignale mit ihren Koeffizienten multipliziert und zum Arc-Erkennungssignal addiert. Es versteht sich, dass auch der Koeffizient, der dem Multiplikator 24 zugeführt wird, ebenfalls korrigiert wird.

Dieser Prozess findet fortlaufend statt und führt zu einer immer sicherer werdenden Arc-Detektion, indem die Koeffizienten für Beobachtungssignale mit hohen Unregelmäßigkeiten bei Indizien für einen Arc schneller wachsen. Der Faktor ε, mit dem die Koeffizienten beeinflusst (erneuert) werden, kann im Laufe der Zeit immer kleiner gemacht werden, um die Koeffizienten immer stabiler zu halten. Bleibt der Faktor ε ungleich Null, so kann auch bei laufendem Betrieb, d.h. bei einem Plasmaprozessbetrieb, die Wichtung der Beobachtungssignale permanent angepasst werden. Der Faktor ε kann nicht nur bei fortschreitender Stabilisierung der Koeffizienten verkleinert werden, sondern auch für verschiedene Beobachtungssignale unterschiedlich sein.

Sind aus einem vorhergehenden Prozess schon Koeffizienten für die Arc-Erkennungsteilsignalgeneratoren 21 - 23 bekannt, so können diese als Anfangswerte der Lernphase verwendet werden. Um kein zu bearbeitendes Material zu schädigen, kann beispielsweise ein Plasmaprozess gefahren werden, der nur der Lernphase dient, wobei die Plasmakammer nur Dummy-Material enthält.

Die Erkennungsschwelle für Arcs im Entscheidungsglied 32 kann dem immer besser werdenden Signal-Rausch-Verhältnis des Arc-Erkennungssignals angepasst werden.

Weiterhin ist es denkbar, statt den Ausgang 33 als Korrelationssignal zu verwenden, das Entscheidungsglied 35 zu verwenden, um ein Korrelationssignal zu erzeugen. Anstatt eines einfachen Entscheidungsprozesses Arc/kein Arc, kann somit eine weichere Entscheidung mit mehreren Stufen erfolgen. Die mehreren Stufen können verschiedene Faktoren für die Erneuerung der Koeffizienten auslösen. Bei einer stufenlosen Betrachtung wird das Arc-Erkennungssignal, das auf der Leitung 31 ausgegeben wird, dauernd mit dem Unregelmäßigkeiten aufweisenden Beobachtungssignal multipliziert, um mit diesem Ergebnis den entsprechenden Koeffizienten zu erneuern. Dieser Fall würde also einer direkten Verbindung der Leitung 31 mit der Leitung 34 entsprechen. Dabei ist aus Stabilitätsgründen auf einen kleinen Faktor ε zu achten. Die Schwellen, die im Entscheidungsweg 35 gesetzt werden, können auch höher sein als die Arc-Erkennungsschwelle im Entscheidungsglied 32. Somit kann ein im Arc-Erkennungssignal detektiertes Arc-Ereignis zwar die bei der Anlage vorgesehenen Arc-Unterdrückungsmaßnahmen auslösen, die Koeffizienten können jedoch nur bei einem (stärkeren) Arc-Ereignis erneuert werden, nämlich nur dann, wenn die Schwelle im Entscheidungsglied 35 überschritten wird. Insbesondere kann nur in diesem Fall ein Korrelationssignal erzeugt werden.

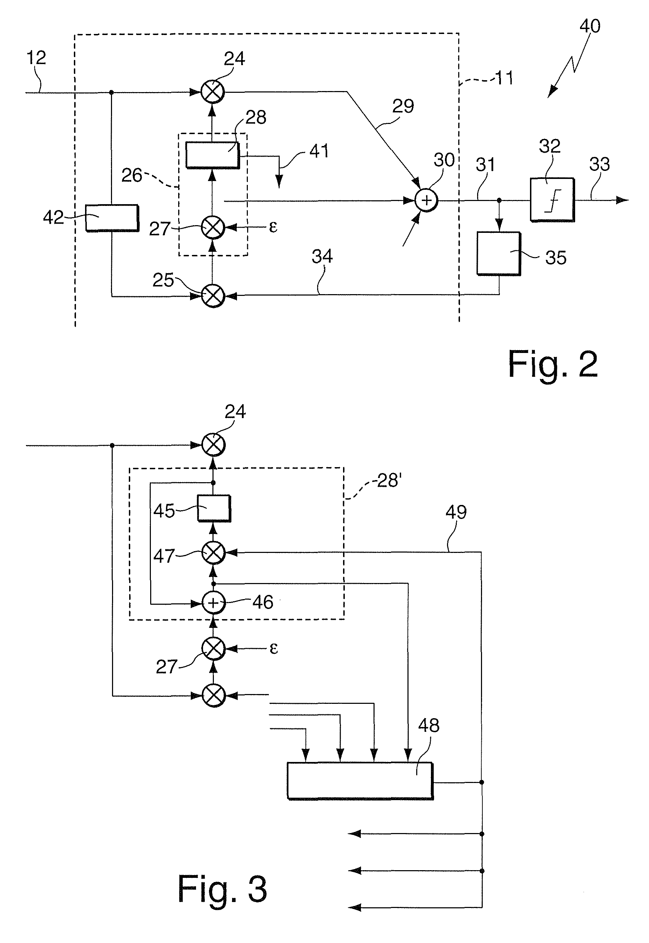

In der Figur 2 ist eine weitere Ausführungsform einer Arc-Erkennungsanordnung 40 gezeigt, wobei Elemente, die denen der Figur 1 entsprechen, mit denselben Bezugsziffern gekennzeichnet sind. In diesem Fall weist der Integrator 28 einen Schwund 41 auf. Dies hat die Folge, dass der Koeffizient, der durch den Koeffizientenerzeuger 26 ausgegeben wird, bei fehlenden oder zu geringen Unregelmäßigkeiten im Beobachtungssignal auf der Leitung 12 gegen Null gezogen wird. Der Schwund kann absolut oder relativ sein. Beispielsweise kann bei jedem erkannten Arc der Schwund wirken. Er sollte jedoch so klein gewählt werden, dass eine genügend große Unregelmäßigkeit im Falle eines Arcs den Koeffizienten schneller beeinflusst als der Schwund. Der Schwund kann für verschiedene Beobachtungssignale unterschiedlich sein.

Weiterhin ist in der Figur 2 ein Glied 42 gezeigt, welches das Beobachtungssignal modifiziert, ehe es dem Multiplikator 25 zugeführt wird. Beispielsweise kann im Glied 42 das Beobachtungssignal mit einer Schwelle verglichen werden und nur ein Signal ausgegeben werden, wenn die Schwelle überschritten wird. Alternativ kann das Beobachtungssignal mit einer Nichtlinearität oder einem Filter versehen werden.

In der Figur 2 ist weiterhin vorgesehen, dass das Korrelationssignal durch das Entscheidungsglied 35 erzeugt wird. Das Arc-Signal auf der Leitung 33 wird demzufolge hier nicht als Korrelationssignal verwendet. Im Entscheidungsglied 35 kann das Arc-Erkennungssignal, welches auf der Leitung 31 ausgegeben wird, mit einer Schwelle, einer Schwelle mit Offset oder mehreren Schwellen verglichen werden oder mit einer Nichtlinearität, beispielsweise einer Quadrierung, versehen werden. Auch andere Maßnahmen zur Modifizierung des Arc-Erkennungssignals zur Umwandlung in ein Korrelationssignal sind denkbar.

Alle in Figur 2 beschriebenen Ausführungsformen, wie der Integrator 28, ein Schwund 41, das modifizierende Glied 42 oder das Entscheidungsglied 35 können je einzeln für sich oder in beliebiger Kombination die Arc-Erkennungsanordnung 10 erweitern.

In der Figur 3 ist die Möglichkeit einer Normierung der Koeffizienten dargestellt. Insbesondere wurde der Koeffizientenerzeuger 26' im Vergleich zu den vorherigen Ausführungsbeispielen modifiziert. Der Integrator 28' weist ein Register 45 auf, welches jedoch lediglich einen Speicher, keine zeitliche Verzögerung, darstellt. Der Ausgang des Registers 45 wird zum einen dem Multiplikator 24 zugeführt und zum anderen einem Addierer 46. Dem Addierer 46 wird weiterhin das Multiplikationsergebnis des Multiplikators 27 zugeführt. Das Additionsergebnis des Addierers 46 wird zum einen einem Multiplikator 47 und zum anderen einem Normierungsglied 48 zugeführt. Dem Normierungsglied 48 werden auch die Koeffizienten der anderen Arc-Erkennungsteilsignaigeneratoren zugeführt, was mit den Pfeilen 36 angedeutet ist. Beispielsweise kann im Normierungsglied 48 die Summe der Absolutwerte aller Koeffizienten gebildet werden. Dieser Wert wird dann über die Leitung 49 auf den Multiplikator 49 rückgeführt, wo eine Multiplikation mit dem vom Addierer 46 ausgegebenen Koeffizienten erfolgt. Das Ergebnis wird in das Register 45 geschrieben und dem Multiplikator 24 zugeführt. Der Normierungsfaktor, d.h. der Ausgang des Normierungsglieds 48, wird auch den anderen Arc-Erkennungsteilsignalgeneratoren zur Normierung der jeweiligen Koeffizienten zugeführt, was mit den Pfeilen 37 angedeutet ist.

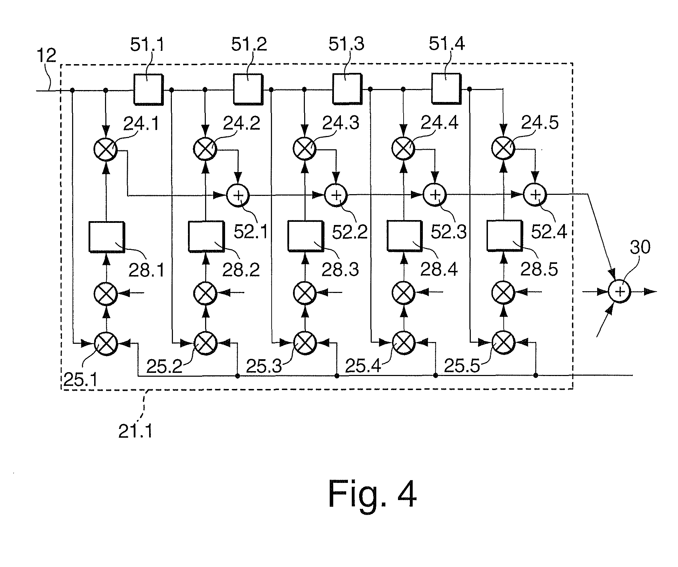

In der Figur 4 ist ein Ausführungsbeispiels gezeigt, bei dem statt eines einzigen Koeffizienten für jedes Beobachtungssignal des Kombinators eine Reihe von Koeffizienten verwendet werden, um zeitliche Unterschiede zwischen den Beobachtungssignalen auszugleichen. Im gezeigten Ausführungsbeispiel weist der Arc-Erkennungsteilsignalgenerator 21.1 entsprechend fünf Multiplikatoren 25.1, 25.2, 25.3, 25.4. 25.5 auf, denen ein Korrelationssignal zugeführt ist. Dem Multiplikator 25.1 ist weiterhin das Beobachtungssignal auf der Leitung 12 zugeführt. Das Beobachtungssignal gelangt außerdem zu Verzögerungsgliedern 51.1, 51.2, 51.3 und 51.4. Das um einen Takt verzögerte Beobachtungssignal gelangt daher zum Multiplikator 25.2, das um zwei Takte verzögerte Beobachtungssignal gelangt zum Multiplikator 25.3, das um drei Takte verzögerte Beobachtungssignal gelangt zum Multiplikator 25.4 und das um vier Takte verzögerte Beobachtungssignal gelangt zum Multiplikator 25.5. Die Multiplikationsergebnisse der Multiplikatoren 25.1 - 25.5 werden in den Multiplikatoren 27.1 - 27.5 mit dem Faktor ε multipliziert und dann den jeweiligen Integratoren 28.1. - 28.5 zugeführt. Die darin erzeugten Koeffizienten werden wiederum den Multiplikatoren 24.1 - 24.5 zugeführt. Die Ergebnisse der Multiplikationen werden in Addierern 52.1 - 52.4 addiert, wobei der Ausgang des Addierers 52.4 das Arc-Erkennungsteilsignal ausgibt, welches dem Addierer 30 zugeführt wird.

Der Arc-Erkennungsteilsignalgenerator 21.1 stellt einen FIR-Filter dar. Die anderen Arc-Erkennungsteilsignalgeneratoren des Kombinators können ebenfalls fünf Koeffizienten generieren oder auch eine davon abweichende Anzahl von Koeffizienten generieren und anhand dieser Koeffizienten ein Arc-Erkennungsteilsignal erzeugen. Für die Erneuerung eines der Koeffizienten im Falle eines detektierten Arcs ist die jeweils im korrespondierenden Verzögerungsglied 51.1 - 51.4 vorhandene Signalamplitude (Unregelmäßigkeit) maßgebend. Eine Arc-Erkennung findet allerdings erst statt, wenn bei einem Arc die Unregelmäßigkeiten auf die höheren Koeffizienten treffen, also frühestens nach fünf Takten. Sind die bei einem Arc erwarteten Unregelmäßigkeiten im Beobachtungssignal bei zwei Beobachtungssignalen gegeneinander verzögert, so werden auch die Koeffizienten für diese beiden Beobachtungssignale diese Verzögerung widerspiegeln und so zu einem zeitlich enger definierten Ereignis auf dem Arc-Erkennungssignal führen. Ebenso wird eine verbreiterte oder mit einer bestimmten Form versehene Unregelmäßigkeit auf einem Beobachtungssignal zu Koeffizienten führen, die dieses Beobachtungssignal optimal auf ein zeitlich engeres Ereignis auf dem Arc-Erkennungssignal abbilden.

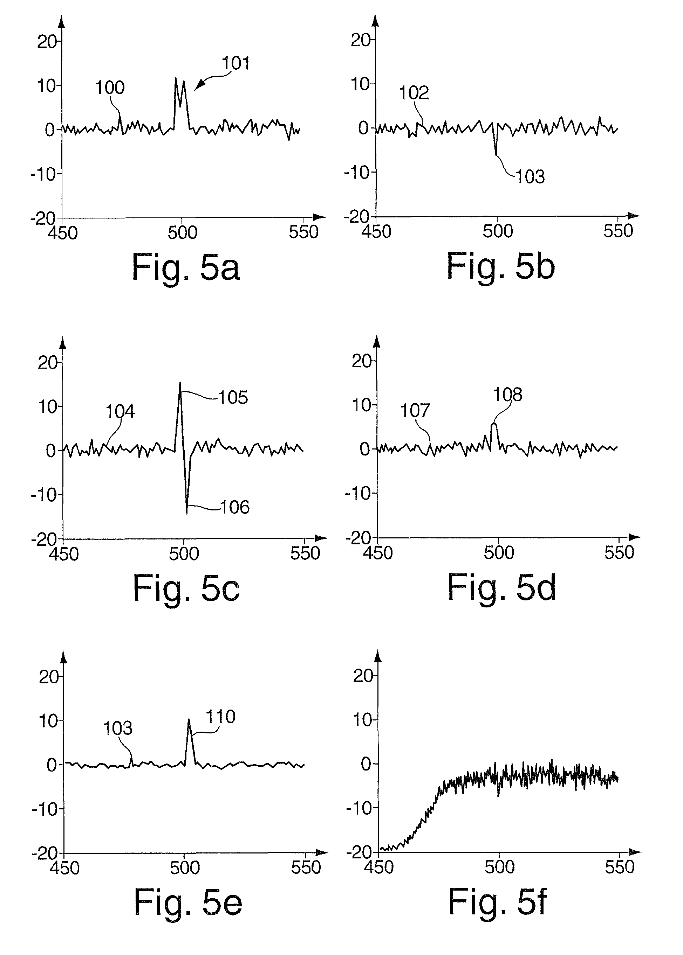

In der Figur 5a bis 5d sind vier Beobachtungssignale 100, 102, 104, 107 dargestellt. Jedes dieser Signale ist an jeweils einen Arc-Erkennungsteilsignalgenerator 21.1, wie in Figur 4 dargestellt, angeschlossen. Das Beobachtungssignal 100 weist im Bereich des Zeitpunkts 500 eine Doppelspitze 101 aufweist. Diese Doppelspitze 101 stellt eine Unregelmäßigkeit dar, die auf einen Arc hindeutet. Diese Unregelmäßigkeit ist positiv.

In der Figur 5b ist ein Beobachtungssignal 102 dargestellt, welches im Bereich des Zeitpunkts 500 eine negative Spitze 103 aufweist.

Das Beobachtungssignal 104, welches in der Figur 5c gezeigt ist, weist sowohl einen positiven Ausschlag 105 als auch einen negativen Ausschlag 106 im Bereich des Zeitpunkts 500 auf.

Das Beobachtungssignal 107 der Figur 5d weist nur eine unscharfe, d.h. nicht klar definierte Unregelmäßigkeit 108 auf.

In der Figur 5e ist das Arc-Erkennungssignal gezeigt, welches unter Berücksichtigung der Beobachtungssignale 100, 102, 104, 107 erzeugt wurde. Im Bereich 500 ist ein klarer Ausschlag 110 zu erkennen.

Die Figur 5f zeigt auf der normierten Zeitachse, wobei für jeden X-Schritt ein Arc-Event dargestellt ist, die Vergrößerung des Signal-Rausch-Verhältnisses des Arc-Erkennungssignals im Laufe der Zeit dar.

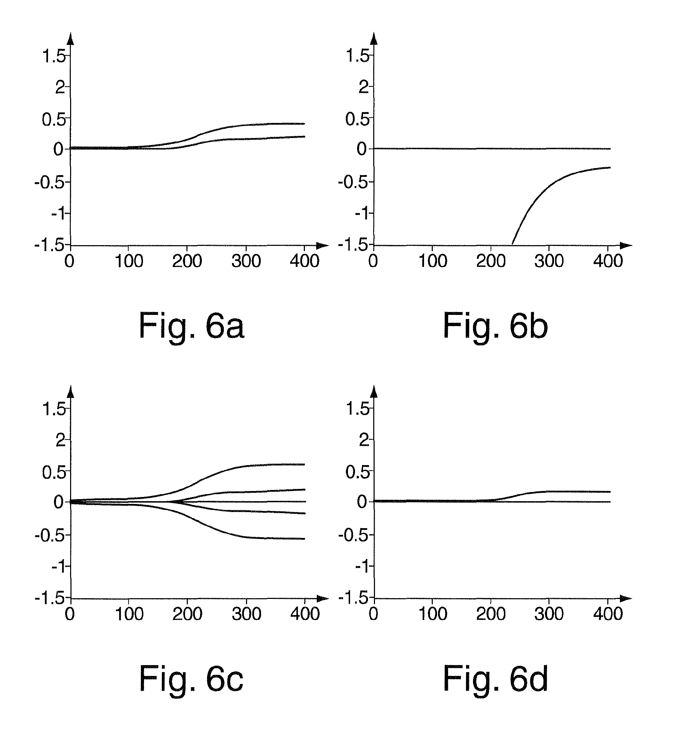

In Figur 6a bis 6d ist der Verlauf der Koeffizienten gezeigt, der sich für die in Figur 5a bis 5d gezeigten Beobachtungssignale 100, 102, 104, 107 ergibt. Das Beobachtungssignal 100 aus Figur 5a erzeugt die Koeffizienten 60.1 bis 60.5 in Figur 6a. Wenn man annimmt, dass das Beobachtungssignal 100 in Figur 4 auf der Leitung 12 zugeführt würde, dann wären die Koeffizienten 60.1 bis 60.5 die Ausgangssignale der Integratoren 28.1 - 28.5. Alle Koeffizienten sind hier zu Beginn auf Null gesetzt. Nach etwa 150 Arc-Events entwickeln sich die Koeffizienten. Die vier Koeffizienten 60.1, 60.2, 60.4, 60.5 steigen etwa gleich stark an und erreichen nach etwa 300 Arc-Events einen statischen Wert von ungefähr 0,5. Der mittlere Koeffizient 60.3 (entspricht dem Ausgang des Integrators 28.3) erreicht ebenfalls nach etwa 300 Arc-Events einen statischen Wert von ungefähr 0,2. Dies entspricht in etwa dem Kurvenverlauf des Beobachtungssignals 100 aus Figur 5a.

In Figur 6b ist der Verlauf der Koeffizienten 61.1 bis 61.5 gezeigt, wie sie am Ausgang der Integratoren 28.1 bis 28.5 aus Figur 4 anliegen würden, wenn man das Beobachtungssignal 102 aus Figur 5b an der Leitung 12 aus Figur 4 anlegen würde. Diesmal wurde der Anfangswert des Koeffizienten 61.3 auf einen stark negativen Wert voreingestellt. Nach etwa 250 Arc-Events ist er so weit angestiegen, dass er in der Grafik Figur 6b sichtbar wird. Erst nach etwa 400 Arc-Events erreicht er einen statischen Wert bei etwa -0,4. Die anderen Koeffizienten bleiben bei ihrem voreingestellten Wert Null.

In Figur 6c ist der Verlauf der Koeffizienten 62.1 bis 62.5 gezeigt, wie sie am Ausgang der Integratoren 28.1 bis 28.5 aus Figur 4 anliegen würden, wenn man das Beobachtungssignal 104 aus Figur 5c an die Leitung 12 aus Figur 4 anlegen würde. Diesmal wurden alle Anfangswerte der Koeffizienten 62.1 bis 62.5 auf Null voreingestellt. Der mittlere Koeffizient 62.3 (entspricht dem Ausgang des Integrators 28.3) bleibt konstant bei Null. Der erste Koeffizient 62.1 (entspricht dem Ausgang des Integrators 28.1) erreicht seinen statischen Wert +0,2 nach etwa 350 Arc-Events. Der zweite Koeffizient 62.2 (entspricht dem Ausgang des Integrators 28.2) erreicht seinen statischen Wert +0,6 nach etwa 300 Arc-Events. Der vierte Koeffizient 62,4 (entspricht dem Ausgang des Integrators 28.4) erreicht seinen statischen Wert -0,6 nach etwa 300 Arc-Events. Der Fünfte Koeffizient 62,5 (entspricht dem Ausgang des Integrators 28.5) erreicht seinen statischen wert -0,2 nach etwa 350 Arc-Events.

In Figur 6d ist der Verlauf der Koeffizienten 63.1 bis 63.5 gezeigt, wie sie am Ausgang der Integratoren 28.1 bis 28.5 aus Figur 4 anliegen würden, wenn man das Beobachtungssignal 107 aus Figur 5d an die Leitung 12 aus Figur 4 anlegen würde. Der mittlere Koeffizient 63.3 (entspricht dem Ausgang des Integrators 28.3) erreicht seinen statischen Wert +0,2 nach etwa 300 Arc-Events. Der erste, der zweite und der vierte Koeffizient 63.1, 63.2, 63.4 entwickeln sich ähnlich wie der mittlere Koeffizient. Nur der fünfte Koeffizient 63.5 bleibt bei Null.

Werden nun die vier Beobachtungssignale 100, 102, 104, 107 jeweils an einen Ar-Erkennungsteilsignalgenerator, wie in 21.1 in Figur 4 dargestellt, angeschlossen und die Ausgänge dieser Arc-Erkennungsteilsignalgeneratoren am Summierpunkt 30 aus Figur 4 zusammengeschlossen, so kann man hier ein sehr sicheres und sich stetig verbesserndes Arc-Erkennungssignal ermitteln.

## Patentansprüche

1. Verfahren zur Erzeugung eines Arc-Erkennungssignals auf Basis mehrerer Beobachtungssignale mit den Verfahrensschritten:
a. Erzeugung je eines Arc-Erkennungsteilsignals für zumindest zwei Beobachtungssignale, wobei das Erzeugen jedes Arc-Erkennungsteilsignals umfasst:
i. Korrelation des zugeordneten Beobachtungssignals oder eines modifizierten Beobachtungssignals mit einem Korrelationssignal, indem das Korrelationssignal mit dem jeweiligen Beobachtungssignal oder modifizierten Beobachtungssignal beeinflusst wird und so ein Korrelationsergebnis erzeugt wird, wobei das Korrelationssignal entweder mit einem vorher ermittelten Arc-Erkennungssignal in Beziehung steht, oder das Korrelationssignal ein unabhängig ermitteltes Arc-Erkennungssignal oder ein extern erzeugtes Signal, das ein Arc-Verhalten im Plasmasystem verursacht oder simuliert, ist;
ii. Erzeugen oder Modifikation eines Koeffizienten auf Basis des Korrelationsergebnisses;
iii. Wichtung des jeweiligen Beobachtungssignals mit einem zugehörigen Koeffizienten;
b. Addition der Arc-Erkennungsteilsignale zu dem Arc-Erkennungssignal.

2. Verfahren nach Anspruch 1, **dadurch gekennzeichnet, dass** das Korrelationsergebnis mit einem Faktor multipliziert wird und vorzeichenrichtig zu dem Koeffizienten zur Bildung eines aktualisierten Koeffizienten addiert wird.

3. Verfahren nach einem der vorhergehenden Ansprüche, **dadurch gekennzeichnet, dass** das Korrelationssignal ein Arc-Erkennungssignal, insbesondere ein vorher oder unabhängig vom Verfahren gemäß Anspruch 1 generiertes Arc-Erkennungssignal, ist oder dass das Arc-Erkennungssignal einem Entscheidungsglied zugeführt wird und das Ausgangssignal des Entscheidungsglieds als Korrelationssignal verwendet wird.

4. Verfahren nach einem der vorhergehenden Ansprüche, **dadurch gekennzeichnet, dass** in einem Entscheidungsglied das Arc-Erkennungssignal mit einer oder mehreren Schwellen verglichen wird, mit einem Offset versehen wird und/oder auf das Arc-Erkennungssignal eine Nichtlinearität angewendet wird.

5. Verfahren nach einem der vorhergehenden Ansprüche, **dadurch gekennzeichnet, dass** zumindest ein Beobachtungssignal mit zumindest einer Schwelle verglichen wird oder auf das Beobachtungssignal eine Nichtlinearität angewendet wird , ehe es mit dem Korrelationssignal korreliert wird.

6. Verfahren nach einem der vorhergehenden Ansprüche, **dadurch gekennzeichnet, dass** die Größe zumindest eines Koeffizienten begrenzt wird.

7. Verfahren nach einem der vorhergehenden Ansprüche, **dadurch gekennzeichnet, dass** die Koeffizienten normiert werden.

8. Verfahren nach einem der vorhergehenden Ansprüche, **dadurch gekennzeichnet, dass** zumindest ein Koeffizient zur gezielten Über-oder Unterbewertung des damit gewichteten Beobachtungssignals korrigiert wird.

9. Verfahren nach einem der vorhergehenden Ansprüche, **dadurch gekennzeichnet, dass** zumindest ein Koeffizient mit einem Schwund beaufschlagt wird.

10. Verfahren nach einem der vorhergehenden Ansprüche,
**dadurch gekennzeichnet, dass** zumindest ein Beobachtungsignal erzeugt wird, indem ein Messsignal verstärkt, gefiltert, nach der Zeit abgeleitet, mit seinem Rauschen normiert und/oder mathematisch bearbeitet wird.

11. Verfahren nach einem der vorhergehenden Ansprüche,
**dadurch gekennzeichnet, dass** zumindest ein Beobachtungssignal mit mehreren Koeffizienten gewichtet wird.

12. Verfahren nach Anspruch 11, **dadurch gekennzeichnet, dass** das zumindest eine Beobachtungssignal nach unterschiedlichen zeitlichen Verzögerungen mit den Koeffizienten gewichtet wird.

13. Arc-Erkennungsanordnung (10) eines Plasmasystems zur Erzeugung eines Arc-Erkennungssignals, mit einem Kombinator (11), dem mehrere Beobachtungssignale zugeführt sind, umfassend
a. Zumindest zwei Arc-Erkennungsteilsignalgeneratoren (21, 22, 23, 21.1), denen jeweils ein Beobachtungssignal zugeführt ist, jeweils aufweisend
i. einen Multiplikator (24, 24.1 - 24.5) zur Multiplikation des Beobachtungssignals mit einem Koeffizienten
ii. einen Korrelator (25, 25', 25", 25.1 - 25.5) zur Korrelation des Beobachtungssignals mit einem Korrelationssignal, wobei das Korrelationssignal entweder mit einem vorher ermittelten Arc-Erkennungssignal in Beziehung steht, oder das Korrelationssignal ein unabhängig ermitteltes Arc-Erkennungssignal oder ein extern erzeugtes Signal, das ein Arc-Verhalten im Plasmasystem verursacht oder simuliert, ist;
iii. einem Koeffizientenerzeuger (26, 26.1 - 26.5), der mit dem Korrelator (25, 25', 25", 25.1 - 25.5) und dem Multiplikator (24, 24.1 - 24.5) in Verbindung steht,
b. einen Addierer (30), dem die Arc-Erkennungsteilsignale zugeführt sind und der das Arc-Erkennungssignal ausgibt.

14. Arc-Erkennungsanordnung nach Anspruch 13, **dadurch gekennzeichnet, dass** der Koeffizientenerzeuger (26, 26.1 - 26.5) einen Integrator (28, 28.1 - 28.5) umfasst.

15. Arc-Erkennungsanordnung nach einem der vorhergehenden Ansprüche 13 oder 14, **dadurch gekennzeichnet, dass** ein Normierungsglied (48) vorgesehen ist, dem die Koeffizienten zugeführt sind und dessen Ausgang mit jeweils einem Multiplikator (50) in den Koeffizientenerzeugern verbunden ist.

## Claims

1. Method for producing an arc detection signal on the basis of a plurality of observation signals having the method steps:
a. production of an arc detection part-signal for each of at least two observation signals, the production of each arc detection part-signal comprising:
i. correlation of the associated observation signal or a modified observation signal with a correlation signal by the correlation signal being influenced with the respective observation signal or modified observation signal and a correlation result thus being produced, whereby either the correlation signal is related to a previously established arc detection signal or the correlation signal is an arc detection signal which has been established in an independent manner or is an externally produced signal which brings about or simulates an arc behaviour in the plasma system;
ii. production or modification of a coefficient on the basis of the correlation result;
iii. weighting of the respective observation signal with an associated coefficient;
b. addition of the arc detection part-signals to form the arc detection signal.

2. Method according to claim 1, **characterised in that** the correlation result is multiplied with a factor and is added with the correct preceding sign to the coefficient in order to form an updated coefficient.

3. Method according to either of the preceding claims, **characterised in that** the correlation signal is an arc detection signal, in particular an arc detection signal which is generated previously or independently of the method according to claim 1, or **in that** the arc detection signal is supplied to a decision member and the output signal of the decision member is used as a correlation signal.

4. Method according to any one of the preceding claims, **characterised in that**, in a decision member, the arc detection signal is compared with one or more thresholds, provided with an offset and/or a non-linearity is applied to the arc detection signal.

5. Method according to any one of the preceding claims, **characterised in that** at least one observation signal is compared with at least one threshold or a non-linearity is applied to the observation signal before it is correlated with the correlation signal.

6. Method according to any one of the preceding claims, **characterised in that** the size of at least one coefficient is limited.

7. Method according to any one of the preceding claims, **characterised in that** the coefficients are normalised.

8. Method according to any one of the preceding claims, **characterised in that** at least one coefficient is corrected for selective overvaluation or undervaluation of the observation signal which is weighted therewith.

9. Method according to any one of the preceding claims, **characterised in that** at least one coefficient is acted on with a shrinkage.

10. Method according to any one of the preceding claims, **characterised in that** at least one observation signal is produced by a measurement signal being amplified, filtered, differentiated according to time, normalised with the noise thereof and/or mathematically processed.

11. Method according to any one of the preceding claims, **characterised in that** at least one observation signal is weighted with a plurality of coefficients.

12. Method according claim 11, **characterised in that** at least one observation signal is weighted with the coefficients after different time delays.

13. Arc detection arrangement (10) of a plasma system for producing an arc detection signal, having a combiner (11), to which a plurality of observation signals are supplied, comprising:
a. at least two arc detection part-signal generators (21, 22, 23, 21.1) to each of which an observation signal is supplied, each having:
i. a multiplier (24, 24.1 - 24.5) for multiplication of the observation signal with a coefficient;
ii. a correlator (25, 25', 25", 25.1 - 25.5) for correlation of the observation signal with a correlation signal, whereby either the correlation signal is related to a previously established arc detection signal or the correlation signal is an arc detection signal which has been established in an independent manner or is an externally produced signal which brings about or simulates an arc behaviour in the plasma system;
iii. a coefficient producer (26, 26.1 - 26.5) which is connected to the correlator (25, 25', 25", 25.1 - 25.5) and the multiplier (24, 24.1 - 24.5);
b. an adder (30), to which the arc detection part-signals are supplied and which outputs the arc detection signal.

14. Arc detection arrangement according to claim 13, **characterised in that** the coefficient producer (26, 26.1 - 26.5) comprises an integrator (28, 28.1 - 28.5).

15. Arc detection arrangement according to either of the preceding claims 13 or 14, **characterised in that** there is provided a normalisation member (48), to which the coefficients are supplied and whose output is connected in each case to a multiplier (50) in the coefficient producers.

## Revendications

1. Procédé pour générer un signal de reconnaissance d'arc sur la base de plusieurs signaux d'observation, avec les étapes suivantes :
a. la génération respectivement d'un signal partiel de reconnaissance d'arc pour au moins deux signaux d'observation, la génération de chaque signal partiel de reconnaissance d'arc comprenant .
i. la corrélation du signal d'observation associé ou d'un signal d'observation modifié avec un signal de corrélation en ce que le signal de corrélation est influencé respectivement par le signal d'observation ou le signal d'observation modifié et génère ainsi un résultat de corrélation, le signal de corrélation étant en rapport avec un signal de reconnaissance d'arc préalablement déterminé ou bien le signal de corrélation étant un signal de reconnaissance d'arc déterminé indépendamment ou un signal généré de manière externe, lequel provoque ou simule un comportement d'arc dans le système plasma ;
ii. la génération ou modification d'un coefficient sur la base du résultat de corrélation ;
iii. la pondération du signal d'observation respectif avec un coefficient associé ;
b. l'addition des signaux partiels de reconnaissance d'arc au signal de reconnaissance d'arc.

2. Procédé selon la revendication 1, **caractérisé en ce que** le résultat de corrélation est multiplié par un facteur, et est additionné avec le bon signe au coefficient, pour la formation d'un coefficient actualisé.

3. Procédé selon l'une des revendications précédentes, **caractérisé en ce que** le signal de corrélation est un signal de reconnaissance d'arc, en particulier un signal de reconnaissance d'arc généré préalablement ou indépendamment du procédé selon la revendication 1, ou bien **en ce que** le signal de reconnaissance d'arc est amené à un élément de décision, et **en ce que** le signal de sortie de l'élément de décision est utilisé en tant que signal de corrélation.

4. Procédé selon l'une des revendications précédentes, **caractérisé en ce que**, dans un élément de décision, le signal de reconnaissance d'arc est comparé avec un ou plusieurs seuils, est pourvu d'un décalage et/ou **en ce qu'**une non-linéarité est appliquée au signal de reconnaissance d'arc.

5. Procédé selon l'une des revendications précédentes, **caractérisé en ce qu'**au moins un signal d'observation est comparé avec au moins un seuil ou bien **en ce qu'**une non-linéarité est appliquée au signal d'observation avant de le mettre en corrélation avec le signal de corrélation.

6. Procédé selon l'une des revendications précédentes, **caractérisé en ce que** la taille d'au moins un coefficient est limitée.

7. Procédé selon l'une des revendications précédentes, **caractérisé en ce que** les coefficients sont normés.

8. Procédé selon l'une des revendications précédentes, **caractérisé en ce qu'**au moins un coefficient est corrigé pour la surévaluation ou sous-évaluation ciblée du signal d'observation pondéré avec celui-ci.

9. Procédé selon l'une des revendications précédentes, **caractérisé en ce qu'**au moins un coefficient est soumis à une réduction.

10. Procédé selon l'une des revendications précédentes, **caractérisé en ce qu'**au moins un signal d'observation est généré **en ce qu'**un signal de mesure est renforcé, filtré, dérivé dans le temps, normé avec son bruit et/ou traité mathématiquement.

11. Procédé selon l'une des revendications précédentes, **caractérisé en ce qu'**au moins un signal d'observation est pondéré avec plusieurs coefficients.

12. Procédé selon la revendication 11, **caractérisé en ce que** cet au moins un signal d'observation est pondéré avec les coefficients selon des retards temporels différents.

13. Agencement de reconnaissance d'arc (10) d'un système plasma pour la génération d'un signal de reconnaissance d'arc, avec un combinateur (11) auquel plusieurs signaux d'observation sont amenés, comprenant :
a. au moins deux générateurs de signaux partiels de reconnaissance d'arc (21, 22, 23, 21.1) auxquels respectivement un signal d'observation est amené, présentant respectivement
i. un multiplicateur (24, 24.1 - 24.5) pour la multiplication du signal d'observation par un coefficient
ii. un corrélateur (25, 25', 25'', 25.1 - 25.5) pour la corrélation du signal d'observation avec un signal de corrélation, le signal de corrélation étant en rapport avec un signal de reconnaissance d'arc préalablement déterminé ou bien le signal de corrélation étant un signal de reconnaissance d'arc déterminé indépendamment ou un signal généré de manière externe, lequel provoque ou simule un comportement d'arc dans le système plasma ;
iii. un générateur de coefficient (26, 26.1 - 26.5), lequel est en relation avec le corrélateur (25, 25', 25'' , 25.1 - 25.5) et le multiplicateur (24, 24.1 - 24.5),
b. un additionneur (30) auquel les signaux partiels de reconnaissance d'arc sont amenés et lequel émet le signal de reconnaissance d'arc.

14. Agencement de reconnaissance d'arc selon la revendication 13, **caractérisé en ce que** le générateur de coefficient (26, 26.1 - 26.5) comprend un intégrateur (28, 28.1 - 28.5).

15. Agencement de reconnaissance d'arc selon l'une des revendications 13 ou 14 précédentes, **caractérisé en ce que** l'on prévoit un élément de normalisation (48) auquel les coefficients sont amenés et dont la sortie est reliée respectivement à un multiplicateur (50) dans les générateurs de coefficient.
